# EUROPEAN PATENT APPLICATION

(11) **EP 0 542 479 A1**
(43) Date of publication of application: **19.05.1993**
(21) Application number: 92310150.5
(22) Date of filing: 05.11.1992
(51) Int. Cl.: H01S 3/19, H01S 3/025

(54) **Method of making a semiconductor laser**

(30) Priority: 15.11.1991 US 792560
(71) Applicant: AT&T Corp., New York, NY 10013-2412 (US)
(72) Inventor: Karlicek, Robert Frank, jr., South Plainfield, New Jersey 07080 (US); Katz, Avishay, Westfield, New Jersey 07090 (US); Logan, Ralph Andre, Morristown, New Jersey 07960 (US)
(74) Representative: Watts, Christopher Malcolm Kelway, Dr.

(57) **Abstract**

The disclosed method of making a III-V (e.g., InP-based) etched mesa buried heterostructure laser comprises use of an appropriate metal layer (40) as etch mask and as contact metal, resulting in simplification of manufacture. It also results in a self-aligned process. Appropriate metal layers comprise Mo, W, and/or Re, with W being currently preferred. Most preferred currently is W-silicide. Onto the first metal layer atop the mesa is deposited a second metal layer (52) that comprises Ti, exemplarily is Ti, followed typically by conventional deposition of Au.

## Description

### Field of the Invention

This invention pertains to the field of semiconductor lasers, and to methods of making such lasers.

### Background of the Invention

Current semiconductor manufacturing processes typically are complex, multistep processes. See, for instance, J. D. Wynn et al., Fiber and Integrated Optics, Vol. 9, pp. 267-373.

In particular, the manufacture of EMBH (etched mesa buried heterostructure) lasers typically involves the formation of patterned dielectric stripes on a previously produced multilayer semiconductor wafer. The stripes function as a wet etch mask during mesa etch, as well as a mask for epitaxial re-growth around the mesa. After re-growth the stripes are removed, a new dielectric layer is deposited and patterned to provide a mask for contact metal (typically AuBe) deposition. Subsequently contact metal is deposited and alloyed, followed by deposition of (typically TiPt) barrier metal overlaying the contact metal. This typically is followed by further steps such as electroplating of Au contacts, wafer thinning and cleaving into individual devices.

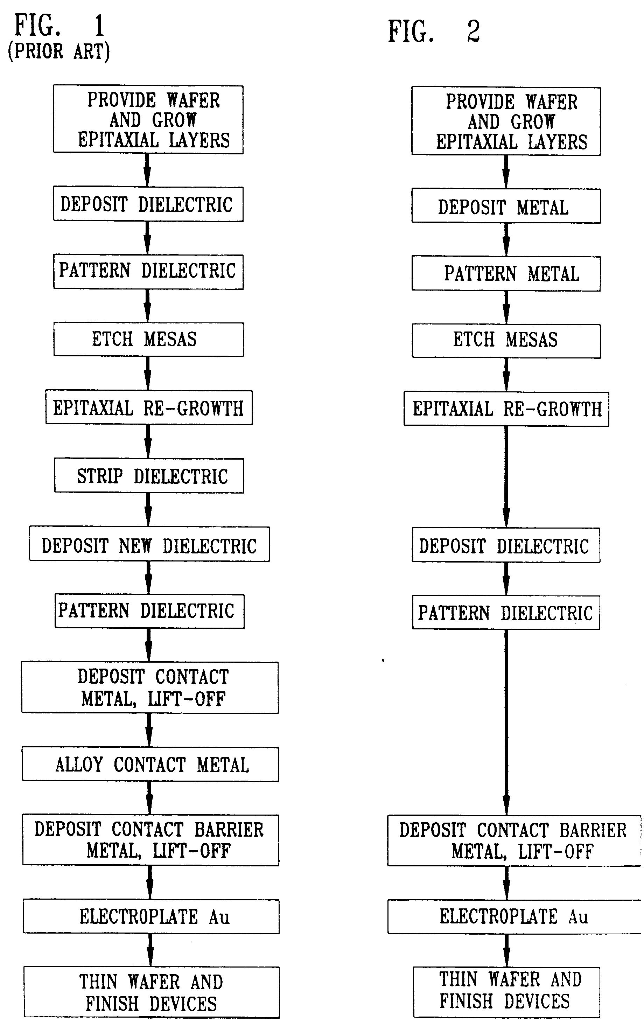

The above description illustrates the complexity of current practice. See also FIG. 1, which shows relevant aspects of the prior art process in form of a flow chart. The complexity of the prior art process contributes to relatively high device cost and low yield, and complicates design optimization, since it generally does not lend itself to early testing of devices. In view of these disadvantages of current practice, a different and less complex manufacturing process would be highly desirable. This application discloses such a process.

### Brief Description of the Drawings

FIG. 1 is a flow diagram showing relevant steps in a prior art laser manufacturing process;
FIG. 2 is a flow diagram that shows analogous relevant steps of a process according to the invention;
FIG. 3 schematically illustrates the layer structure of an exemplary semiconductor wafer;
FIG. 4 schematically depicts the wafer of FIG. 3 after mesa etch; and
FIG. 5 schematically shows relevant aspects of a laser produced according to the invention.

### The Invention

An aspect of the invention is the use of an appropriately chosen metal stripe to replace the dielectric stripe for mesa etching and selective area mesa re-growth, and use of the same metal stripe for ohmic contact metalization. This multiple use of the metal stripe can reduce the number of lithography steps, makes the process self-aligned, makes possible earlier device testing, can lead to reduced metals stress on the epitaxial side of the laser and to reduced wafer handling. These aspects of course can positively impact manufacturing cost and yield.

More particularly, the inventive method of making a III-V semiconductor laser comprises forming, on a major surface of an appropriate multilayer semiconductor body, a patterned first metal layer such that a predetermined portion of the surface is not covered by the first metal. Significantly, the first metal is a refractory metal-comprising metal, including silicides of appropriate silicide-forming refractory metals. The refractory metals of interest herein are those that are relatively inert (at re-growth temperatures) with respect to the relevant III-V material, e.g., InP, and with respect to the gases used during re-growth, exemplarily with respect to H₂ and PH₃. These refractory metals include Mo, W, Re, and alloys thereof. Mo and W form silicides that are useful in the practice of the invention. W is the currently preferred refractory metal, with W-silicide being the currently most preferred first metal. For the sake of clarity, and without implying thereby any limitation, the discussion below will primarily focus on W-silicide.

The method further comprises exposing the uncovered portion of the surface to an etching medium such that an elongate protruding topographic feature (a "mesa") results. Typically the process is carried out such that many mesas are formed simultaneously. Each mesa has a top surface (which is covered by first metal) and two opposed elongate side surfaces, and the method further comprises growing semiconductor material on the semiconductor body such that the "re-growth" material is in contact with the two side surfaces of the mesa, and forming metal contact means on the top surface of the mesa. The latter step comprises depositing a second metal onto the first metal on the top surface of the mesa. The second metal comprises Ti, preferably is Ti. On the second metal typically is deposited a Au contact. The method generally comprises further conventional steps such as wafer thinning, reverse side metalization and cleaving.

FIG. 2 shows relevant aspects of the novel process in form of a flow chart. Neither FIG. 1 nor FIG. 2 shows process steps that pertain to the reverse side of the wafer, e.g., reverse side metallization. These steps are well known.

An appropriate metal layer will, inter alia, have good resistance to wet (chemical) anchor dry (plasma) etching to produce the laser mesa. It will be substantially inert with regard to the epitaxial re-growth process while providing good selectivity for the re-growth, will have a substantially stable semiconductor/metal interface at the relevant processing temperatures (e.g., the re-growth temperature), and have good ohmic contact performance.

We have found that, among others, tungsten silicide (WSi for short; this notation does not imply any particular stoichiometry WSiₓ; exemplarily x is in the range 1 to 2) and tungsten are appropriate metals for the practice of the invention, with the former being currently most preferred. The metal layer can be deposited by any suitable method, e.g., sputtering or vapor deposition. Although such a metal layer is most advantageously used in the manufacture of InP-based EMBH lasers, the invention is not so limited. For instance, a metal layer substantially as described can be used in the manufacture of GaAs-based EMBH lasers according to the invention.

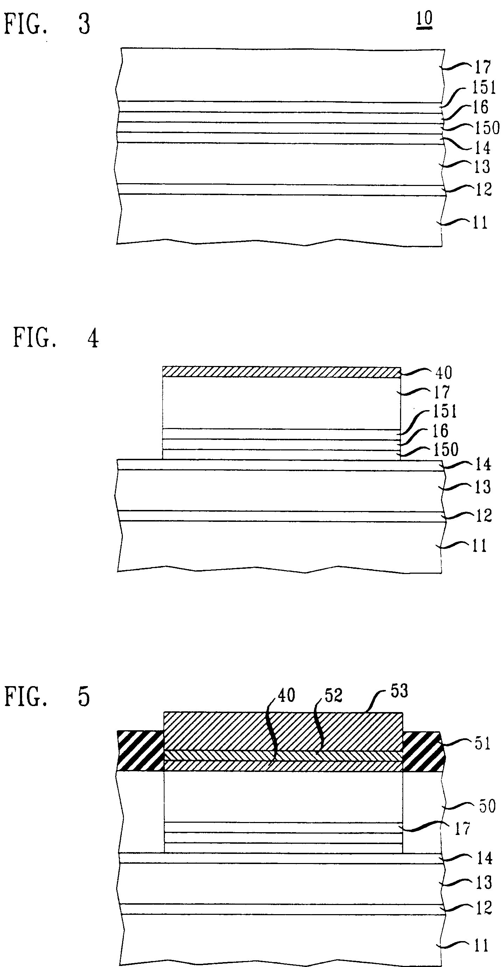

An exemplary epitaxial layer structure 10 for laser manufacture is shown in FIG. 3, wherein numeral 11 refers to the substrate, exemplarily a p-doped InP wafer. For the sake of clarity, the below recited exemplary epitaxial layer sequence on 11 is selected to be appropriate for an InP substrate. If the invention is to be embodied in other III-V lasers (e.g., in GaAs-based lasers), then other layer structures will be appropriate, as will be evident to those skilled in the art.

Substrate 11 supports (optional) diffusion-limiting layer 12, exemplarily a Zn-doped (2 x10¹⁸ cm⁻³) InGaAs layer. This layer in turn supports buffer layer 13, exemplarily a Zn-doped (2x10¹⁸ cm⁻³) InP layer. Optional layer 14 is thin (75 nm) undoped InP layer provided to further reduce the diffusion of Zn into the active layer 16. The active layer [exemplarily 0.15 µm of InGaAsP (λ = 1.3 µm)] is sandwiched between symmetrically graded index layers 150 and 151 whose quaternary composition is continuously graded from λ = 1.05 µm to λ = 1.3 µm over a thickness of 0.12 µm. Numeral 17 refers to the cladding layer, exemplarily 2.0 µm S-doped InP, with the top 0.3 µm doped to about 5x10¹⁹ cm⁻³, and the remainder doped to about 10¹⁸ cm⁻³. Specification of the composition of quaternary material by means of a corresponding wavelength λ is well known and does not require elaboration.

Next will be described an exemplary and currently preferred embodiment of the invention. It will be appreciated that practice of the invention does not require the use of any particular multilayer structure. For instance, the invention can be readily embodied in quantum well lasers, including DFB quantum well lasers.

On a multilayer structure as shown in FIG. 3 and described above, grown by conventional atmospheric pressure MOCVD at 625°C, was deposited a 100 nm layer of WSi by conventional RF sputtering from a single WSi target at an Ar pressure of about 10 mTorr (about 1.33 Pa). The deposited metal had approximate composition WSi₂. By means of conventional photolithography, 6µm wide stripes were then etched in the WSi layer. Etching was carried out in a hybrid Electron Cyclotron Resonance/Radio Frequency plasma etching system using 1:1 SF₆:Ar, with a total flow rate of 20 sccm. The operating pressure was about 1 mTorr (about 0.133 Pa), and about 150W of microwave power was applied, with a DC bias of -50V on the sample. Under these conditions, the etch rate was about 15 nm/min, with substantially infinite selectivity with respect to the underlying InP. The sample was overetched for about 2 minutes to insure that the exposed WSi is cleared over the whole wafer. The above etching conditions are exemplary only, and those skilled in the art will be readily able to determine conditions suitable for available apparatus.

The thus produced WSi stripes served as etch masks for the subsequent wet chemical mesa etch, as shown schematically in FIG. 4, wherein numeral 40 refers to the WSi stripe.

The exposed upper cladding layer was etched using 3:1 HCl:H₃PO₄. The exposed active layer was then dissolved in 4:1:1 H₂SO₄:H₂O₂:H₂O₂. The recited etchants are exemplary only, as those skilled in the art will appreciate.

After completion of the mesa etch, re-growth of Fe-doped InP was carried out in conventional MOCVD apparatus at atmospheric pressure and 500°C. The conventional growth chemistry was modified by the addition of 0.25 sccm 1, 1, 1-trichloroethane (TCE) during growth, to improve re-growth morphology next to the mesa and to enhance selectivity for the re-growth. Those skilled in the art will understand that MOCVD is not the only growth technique that can be used for regrowth in a process according to the invention, and any suitable technique (e.g., hydride and chloride vapor phase epitaxy (VPE)) is contemplated.

Following re-growth, a 300 nm thick layer of SiO₂ was deposited by plasma-enhanced CVD and patterned by conventional photolithography and etching. Subsequently, the wafer was thinned and a conventional AuBe metallization layer vapor-deposited on the p-InP side of the wafer. The n-side metallization was then completed by the evaporation of 10 nm of Ti, and lift-off of those portions of the Ti layer that were supported by dielectric. This was followed by conventional Au electrodeposition. The resulting structure is schematically depicted in FIG. 5, wherein numerals 50 and 51 refer, respectively, to the epitaxial semiconductor regrowth and the patterned dielectric layer. Numeral 52 refers to the Ti barrier layer that supports Au layer 53. The wafer was then cleaved into 250µm long strips for testing. The lasers performed satisfactorily, typically exhibiting, for instance, a threshold at room temperature of about 25 mA, with a slope efficiency of about 0.16 mW/mA. The described laser is exemplary only and is not optimized for high performance.

## Claims

1. Method of making a III-V semiconductor laser that comprises
a) providing a III-V semiconductor body comprising a multiplicity of epitaxial III-V semiconductor layers and having a major surface;
b) forming a patterned material layer on the major surface such that a predetermined portion of said surface is not covered by said layer, and exposing the portion of the major surface to an etching medium such that an elongate protruding topographic feature (a "mesa") results, the mesa having a top surface and two opposed elongate side surfaces;
c) growing epitaxial semiconductor material on the semiconductor body such that the semiconductor material is in contact with said two side surfaces;
d) forming metal contact means on said top surface; and
e) carrying out one or more further steps towards completion of the laser,
CHARACTERIZED IN THAT
f) the material layer is a first metal layer (40) that comprises a refractory metal selected from Mo, W, and Re; and
g) step d) comprises depositing a second metal (52) onto the first metal-covered top surface of the mesa, the second metal comprising Ti.

2. Method of claim 1, wherein the semiconductor body comprises InP.

3. Method of claim 1, wherein the first metal is selected from the group consisting of W and W-silicide.

4. Method of claim 1, wherein the second metal is Ti, and step g) further comprises depositing Au onto the second metal.

5. Method of claim 2, wherein step c) comprises exposing the semiconductor body to a growth atmosphere that comprises In- and P-containing precursor gases, and that further comprises a Cl-containing gas.

6. Method of claim 5, wherein the Cl-containing gas is trichloroethane.
